(19) Europäisches Patentamt
European Patent Office
Office européen des brevets

(11) Veröffentlichungsnummer: **0 193 166 B1**

# (12) EUROPÄISCHE PATENTSCHRIFT

(45) Veröffentlichungstag der Patentschrift: **08.05.91**

(51) Int. Cl.$^5$: **G03F 7/022**

(21) Anmeldenummer: **86102431.3**

(22) Anmeldetag: **25.02.86**

## (54) Lichtempfindliches Gemisch und lichtempfindliches, positiv arbeitendes Kopiermaterial.

(30) Priorität: **28.02.85 US 706817**

(43) Veröffentlichungstag der Anmeldung:
**03.09.86 Patentblatt 86/36**

(45) Bekanntmachung des Hinweises auf die Patenterteilung:
**08.05.91 Patentblatt 91/19**

(84) Benannte Vertragsstaaten:
**DE FR GB IT NL**

(56) Entgegenhaltungen:
**EP-A- 0 051 185**
**EP-A- 0 052 788**
**EP-A- 0 092 444**
**DE-A- 3 309 222**
**US-A- 3 106 465**

(73) Patentinhaber: **HOECHST CELANESE CORPORATION**
**Route 202-206 North**
**Somerville, N.J. 08876(US)**

(72) Erfinder: **Kelly, Michael G.**
**Juniper Hill Drive**
**Coventry Rhode Island 02816(US)**
Erfinder: **Mammato, Donald**
**Fawn Drive. RD No. 1**
**Lebanon, NJ 08833(US)**
Erfinder: **Durham, Dane**
**RD No. 1, Box 372**
**Bloomsbury, NJ 08804(US)**
Erfinder: **Jain, Sangya**
**988 Robin Road**
**Somerville, NJ 08876(US)**
Erfinder: **Crane, Lawrence**
**2325 Fuschia Lane**
**Tustin California 92680(US)**

(74) Vertreter: **Meyer-Dulheuer, Karl-Hermann, Dr. et al**
**HOECHST Aktiengesellschaft Werk Kalle-Albert Zentrale Patentabteilung KA Rheingaustrasse 190 Postfach 3540**
**W-6200 Wiesbaden 1(DE)**

EP 0 193 166 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein lichtempfindliches Gemisch, das einen Naphthochinon-(1,2)-diazid-(2)-sulfonsäureester eines Pyrogallolalkylketons und ein wasserunlösliches, in wäßrig-alkalischen Lösungen lösliches oder mindestens quellbares harzartiges Bindemittel enthält und ein lichtempfindliches, positiv arbeitendes Kopiermaterial, insbesondere zur Herstellung von Photoresists.

Die Herstellung positiv arbeitender Kopiermaterialien ist bekannt und beispielsweise in US-A 3,666,473 und DE-A 30 40 157, EP-A 0 051 185 und in EP-A 0 092 444 bechrieben. Dazu gehören alkalilösliche Phenol-Formaldehyd-Novolakharze in Verbindung mit lichtempfindlichen Substanzen, in der Regel substituierten Naphthochinondiazidverbindungen. Die Harze und Sensibilisatoren werden in einem organischen Lösemittel oder Lösemittelgemisch gelöst und in dünner Schicht auf einen für den jeweiligen Zweck geeigneten Schichtträger aufgetragen.

Die Novolakharzkomponente dieser Photoresistgemische ist in wäßrig-alkalischen Lösungen löslich, doch übt der Sensibilisator auf Naphthochinonbasis eine lösungshemmende Wirkung auf das Harz aus. Bei Belichtung ausgewählter Bereiche des beschichteten Trägers mittels aktinischer Strahlung erfährt der Sensibilisator jedoch eine belichtungsbedingte strukturelle Umwandlung und die Löslichkeit der belichteten Schichtbereiche wird größer als die der unbelichteten Bereiche. Aufgrund dieses unterschiedlichen Lösungsverhaltens werden die belichteten Bereiche der lichtempfindlichen Schicht beim Eintauchen des Schichtträgers in eine alkalische Entwicklerlösung abgelöst, während die nicht belichteten Bereiche im wesentlichen unverändert erhalten bleiben, so daß auf dem Schichtträger ein positives Reliefbild erhalten wird.

In den meisten Fällen wird der belichtete und entwickelte Schichtträger noch mit einem Ätzmittel behandelt. Die lichtempfindliche Photoresistschicht schützt die beschichteten Bereiche des Schichtträgers vor dem Ätzmittel, das folglich nur auf die schichtfreien Bereiche, d.h. im Fall eines positiv arbeitenden Photoresists, auf die belichteten Bereiche, einwirken kann. Auf diese Weise wird auf dem Schichtträger ein Ätzbild erzeugt, das der Maske, Schablone oder sonstigen Vorlage entspricht, durch die vor dem Entwikkeln belichtet wurde.

Das nach dem beschriebenen Verfahren auf dem Schichtträger erzeugte Photoresistreliefbild ist für verschiedene Anwendungszwecke geeignet, z. B. als Belichtungsmaske oder als Vorlage bei der Herstellung von integrierten elektronischen Mikrobauteilen.

Zu den Kriterien, nach denen die Eignung eines Photoresistgemisches für kommerzielle Zwecke beurteilt wird, zählen die Lichtempfindlichkeit des Photoresists, der Kontrast nach der Entwicklung, die Resistauflösung und die Haftung der Resistschicht auf dem Schichtträger.

Hohe Lichtempfindlichkeit ist für einen Photoresist insbesondere in solchen Fällen von Bedeutung, wo Licht geringerer Intensität verwendet wird, z. B. bei Projektionsbelichtungsverfahren, bei denen das Licht durch eine Reihe von Linsen und monochromatischen Filtern geleitet wird.

Der Kontrast beim Entwickeln ist ein Maßstab für die Fähigkeit des Photoresists, die Abmessungen der Maske zuverlässig und genau durch die gesamte Dicke der Photoresistschicht hindurch zu übertragen. Im Idealfall haben die Ausnehmungen an der Oberseite der Resistschicht genau die gleichen Abmessungen wie an der Unterseite der Resistschicht. Ein Photoresist mit verbessertem Kontrast besitzt also steilere Flanken.

Die Resistauflösung betrifft das Vermögen eines Photoresistsystems, auch die feinsten Linien und Zwischenräume einer für die Belichtung verwendeten Maske wiederzugeben, wobei die belichteten und entwickelten Bereiche ein hohes Maß an Kantenschärfe aufweisen.

Auf vielen industriellen Einsatzgebieten, insbesondere bei der Herstellung von elektronischen Mikrobauteilchen, muß der eingesetzte Photoresist auch noch bei sehr geringen Linien- und Abstandsbreiten eine hohe Auflösung ergeben (1 $\mu$m und weniger). Diese Eigenschaft, d. h., die Fähigkeit zur Wiedergabe von Bildstellen sehr geringer Abmessungen, in einem Größenbereich von 1 $\mu$m oder weniger, ist für die großtechnische Herstellung integrierter Schaltungen auf Siliziumscheiben und ähnlicher Bauteile von entscheidender Bedeutung.

Die Integrationsdichte auf einem solchen Chip kann beim Einsatz photographischer Verfahren nur durch eine Steigerund des Auflösungsvermögens des Photoresists erhöht werden.

Es war deshalb Aufgabe der vorliegenden Erfindung ein verbessertes lichtempfindliches Gemisch und ein lichtempfindliches, positiv arbeitendes Kopiermaterial wie einen positiv arbeitenden Photoresist zu schaffen, das sich durch einen gesteigerten Kontrast auszeichnet, wobei die Lichtempfindlichkeit des Resists im nahen UV-Bereich die Lichtempfindlichkeit des Resists im nahen UV-Bereich erhalten bleibt oder sogar noch gesteigert wird.

Die Lösung dieser Aufgabe geht aus von einem lichtempfindlichen Gemisch der eingangs genannten

Art und ist dadurch gekennzeichnet, daß es einen Naphthochinondiazidsulfonsäureester der allgemeinen Formel enthält.

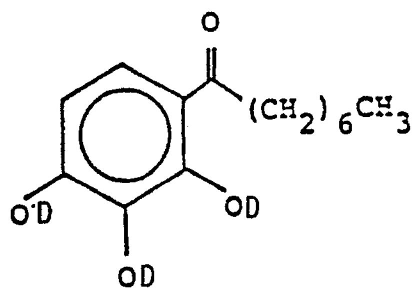

worin

D einen Naphthochinon-(1,2)-diazid-(2)-4-sulfonyl- oder einen Naphthochinon-(1,2)-diazid-(2)-5-sulfonyl-Rest bedeutet.

Als Bindemittel enthält das Gemisch vorzugsweise einen Phenolharz-Novolak, einen Kresolharz-Novolak oder ein Polyvinylphenolharz.

Hierdurch wird ein lichtempfindliches Gemisch zur Verfügung gestellt, das einen recht hohen Bildkontrast gewährleistet, während gleichzeitig nur eine geringe Belichtungsenergie erforderlich ist um die belichteteten Bestandteile vollständig zu entfernen.

Die im erfindungsgemäßen Gemisch enthaltenen Naphthochinonderivate werden nach bekannten Verfahren hergestellt, z. B. durch Kombination eines Mols der Trihydroxyphenylheptylketonverbindung nach der Formel

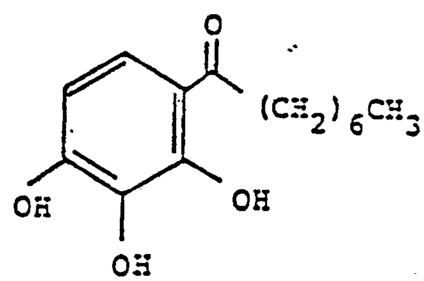

und drei Mol Naphthochinon-(1,2)-diazid-(2)sulfonylchlorid in einem inerten Lösungsmittel in Gegenwart einer schwachen Base. Die Herstellung von Trihydroxyphenylalkylketonen erfolgt ebenfalls in bekannter Weise, zum Beispiel durch Umsetzen von Pyrogallol mit der entsprechenden aliphatischen Säure, bzw. dem entsprechenden aliphatischen Säurechlorid, in Gegenwart eines geeigneten Katalysators, gegebenenfalls in einem geeigneten Lösemittel, wobei die Reaktion nach dem folgenden Schema abläuft

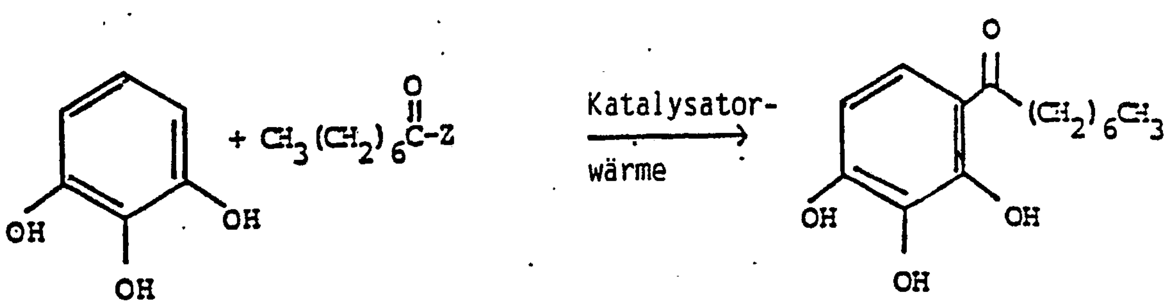


in dem Z- Chlor oder die Hydroxylgruppe bedeutet. Geeignete Katalysatoren für diese Reaktion sind beispielsweise Aluminiumchlorid, Bortrifluorid, anelliertes Zinkchlorid, Trifluormethansulfonsäure und Polyphosphorsäure. Zu den geeigneten Lösemitteln zählen Ether, 1,2-Dichlorethan, Methylenchlorid und Anisol.

Der Naphthochinon-(1,2)-diazid-(2)-sulfonylrest D ist ein Naphthochinon-(1,2)-diazid-(2)-4-sulfonylrest oder bevorzugt ein Naphthochinon-(1,2)-diazid-(2)-5-sulfonylrest.

Das lichtempfindliche Gemisch der Erfindung wird in einem lichtempfndlichen, positiv arbeitenden Kopiermaterial, insbesondere zur Herstellung von Photoresists verwendet, das aus einem Schichtträger und einer lichtempfindlichen Schicht besteht, die ein Naphthochinon-(1,2)-diazid-(2)-sulfonsäureester eines Pyrogallolalkylketons und ein wasserunlösliches, in wäßrig-alkalischen Lösungen lösliches oder mindestens quellbares harzartiges Bindemittel enthält. Es ist dadurch gekennzeichnet, daß der Naphthochinondiazidsulfonsäureester der allgemeinen Formel entspricht

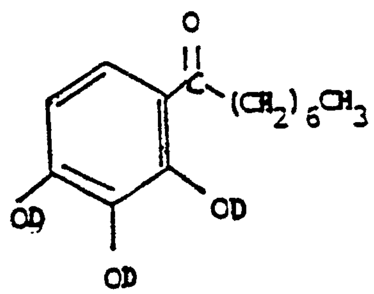

worin

D einen Naphthochinon-(1,2)-diazid-(2)-4-sulfonyl- oder einen Naphthochinon-(1,2)-diazid-(2)-5-sulfonyl-Rest bedeutet.

Das erfindungsgemäße Bindemittel ist ein polymeres, wasserunlösliches harzartiges Bindemittel, das in den für das erfindungsgemäße Gemisch verwendeten Lösemitteln löslich ist, und das außerdem in wäßrig-alkalischen Lösungen löslich oder zumindest quellfähig ist. Vorzugsweise ist das Harz ein Harz auf Hydroxyarylbasis, wie zum Beispiel ein Novolak oder Polyvinylphenolharz, insbesondere ein Phenol-oder ein Kresolnovolakharz. Solche Harze fördern beim Entwickeln eine scharfe Differenzierung zwischen den belichteten und den unbelichteten Teilen der lichtempfindlichen Schicht. Die Herstellung der Novolakharze erfolgt in bekannter Weise und ist beispielhaft beschrieben in A. Knop und W. Scheib, "Chemistry and Application of Phenolic Resins" (Chemie und Anwendungsgebiete von Phenolharzen), Springer-Verlag, New York, 1979, Kapitel 4.

Bei der Herstellung der für die Produktion von Photoresists verwendeten Beschichtungslösung wird soviel an Naphthochinonderivat zugesetzt, bis die Lösung ein bestimmtes Absorptionsvermögen besitzt. Das Absorptionsvermögen beträgt bevorzugt etwa 0,5 bis 1,5 1/g cm, insbesondere etwa 0,6 bis 0,9 1/g cm.

Dazu werden die erfindungsgemäßen Naphthochinonderivate mit dem Bindemittel bevorzugt in einem Gewichtsverhältnis von mindestens 1:1 bis etwa 1:10, insbesondere von etwa 1:6 bis 1:10 gemischt.

Der Lösung aus Bindemittel, Sensibilisator und Lösemittel können noch Zusatzstoffe, wie Farbstoffe, Mittel zur Verhinderung von Streifenbildung, Weichmacher, Haftvermittler, die Lichtempfindlichkeit erhöhende Stoffe, weitere Lösemittel und Netzmittel, z. B. nichtionische Netzmittel, beigemischt werden.

Beispiele für geeignete Farbstoffe sind Methylviolett 2B (C.I. 42 535), Kristallviolett (C.I. 42 555), Malachitgrün (C.I. 42 000), Viktoriablau (C.I. 44 045) und Neutralrot (C.I. 50 040); sie können in einer Menge von 1-10 Gewichtsprozent, bezogen auf das Gesamtgewicht von Bindemittel und Sensibilisator, zugesetzt werden. Die Farbstoffzusätze tragen zu einer besseren Bildauflösung bei, da durch sie eine Rückstreuung des Lichts vom Träger verhindert wird.

Mittel zur Verhinderung von Streifenbildung können in einer Menge bis zu 5 Gewichtsprozent, bezogen auf das Gesamtgewicht von Harz und Sensibilisator, zugesetzt werden.

Geeignete Weichmacher sind beispielsweise Phosphorsäure-tri-($\beta$-chlorethyl)ester, Stearinsäure, Dikampfer, Polypropylen, Acetalharze, Phenoxyharze und Acrylharze. Sie werden in einer Menge von 1-10 Gewichtsprozent, bezogen auf das Gesamtgewicht von Bindemittel und Sensibilisator, zugesetzt. Durch den Zusatz von Weichmachern werden die Beschichtungseigenschaften des Gemisches verbessert, so daß es möglich ist, eine glatte Schicht gleichmäßiger Dicke aufzutragen.

Zu den geeigneten Haftvermittlern zählen $\beta$-(3,4-Epoxycyclohexyl)-ethyltrimethoxysilan, p-Methyldisilanmethylmethacrylat, Vinyltrichlorsilan und $\gamma$-Aminopropyltriethoxysilan. Sie werden in einer Menge bis zu 4 Gewichtsprozent, bezogen auf das Gesamtgewicht von Bindemittel und Sensibilisator, zugesetzt.

Zur Erhöhung der Lichtempfindlichkeit können beispielsweise Pikrinsäure, Nicotinsäure oder Nitrozimtsäure in einer Menge von bis zu 20 Gewichtsprozent, bezogen auf das Gesamtgewicht von Bindemittel und Sensibilisator, zugesetzt werden. Durch diese Stoffe wird die Löslichkeit der lichtempfindlichen Schicht sowohl an den belichteten als auch an den unbelichteten Stellen erhöht. Diese Stoffe werden daher in den

Fällen beigemischt, wo vor allem auf eine zügige Entwicklung Wert gelegt wird, auch wenn dies auf Kosten des Kontrastes geht. Die Einbuße an Kontrast rührt daher, daß nach dem Zusatz von die Lichtempfindlichkeit steigernden Mitteln der Entwickler nicht nur die belichteten Stellen der lichtempfindlichen Schicht schneller löst, sondern daß auch an den unbelichteten Stellen ein erhöhter Schichtverlust eintritt.

Geeignete Lösemittel für das lichtempfindliche Gemisch bzw. die lichtempfindliche Schicht sind Xylol, Butylacetat, Propylenglykolmethyletheracetat, Propylenglykolethyletheracetat und deren Mischungen.

Zu den nichtionischen Netzmitteln, die in der das erfindungsgemäße lichtempfindliche Gemisch enthaltenden Lösung eingesetzt werden können, zählen zum Beispiel Nonylphenoxypoly(ethylenoxy)ethanol, Octylphenoxy(ethylenoxy)ethanol und Dinonylphenoxypoly(ethylenoxy)ethanol. Sie werden in einer Menge von bis zu 10 Gewichtsprozent, bezogen auf das Gesamtgewicht von Bindemittel und Sensibilisator, verwendet.

Die fertig zubereitete Lösung wird mit Hilfe gebräuchlicher Verfahren durch Tauchen, Sprühen oder Schleudern, auf einen geeigneten Schichtträger aufgebracht. Bei einem Schleuderverfahren wird etwa der Feststoffgehalt der Lösung auf einen bestimmten Prozentsatz eingestellt, um in Abhängigkeit von der verwendeten Schleudervorrichtung und der Aufschleuderzeit die jeweils gewünschte Schichtdicke zu erzielen.

Als Schichtträger kommen erfindungsgemäß alle geeigneten Materialien in Frage, Metalle, wie Aluminium oder Aluminiumlegierungen, deren Oberflächen vorzugsweise mechanisch oder elektrolytisch aufgerauht und anodisch oxidiert wurden, Kunststoffolien, wie Polyester- oder Polyolefinfolien, Holz, Papier, Halbleitermaterialien (d. h. Stoffe, die erst elektrisch leitfähig werden, wenn sie dotiert werden), wie Silizium oder Galliumarsenid, Keramik und textile Materialien. Bevorzugt wird als Schichtträger ein Wafer auf Siliziumbasis verwendet.

Auf diese Weise hergestellte Photoresistschichten eignen sich besonders gut zum Aufbringen auf Wafer mit thermisch erzeugten Silizium- oder Siliziumdioxidschichten, wie sie bei der Produktion von Miktroschaltelementen verwendet werden.

Als Schichtträger sind ferner zahlreiche polymere Harze geeignet, insbesondere transparente Polymere, wie z. B. Polyester. Außerdem kann der Träger aus dotiertem Siliziumdioxid, Siliziumnitrid, Tantal, Kupfer, Polysilizium, Keramik oder Aluminium/Kupfer-Mischungen bestehen.

Nach dem Beschichten mit dem lichtempfindlichen Gemisch wird der Schichtträger bei etwa 80 °C bis 100 °C getrocknet. Die Trockenschichtdicke beträgt in der Regel etwa 1 µm. Der beschichtete Schichtträger kann anschließend mit aktinischem Licht, insbesondere UV-Strahlung einer Wellenlänge von etwa 350 nm bis 450 nm, bevorzugt von etwa 360 nm bis 440 nm, durch geeignete Photomasken, Negative, Schablonen, Projektionseinrichtungen, usw. belichtet werden.

Anschließend erfolgt die Entwicklung in einer alkalischen Entwicklerlösung, bevorzugt in einer wäßrig-alkalischen Entwicklerlösung auf der Basis Kaliumborat-Lösungen, bei spielsweise vom Typ AZ 400 K, Herst. American Hoechst Corporation, Somerville, New Jersey. Die Lösung wird vorzugsweise unter Stickstoffatmoshäre gehalten. Die Schichtträger bleiben so lange in der Entwicklerlösung, bis die lichtempfindliche Schicht an den belichteten Stellen ganz oder doch fast ganz abgelöst ist.

Im Anschluß an die Entwicklung kann noch eine Wärme- oder Einbrennbehandlung durchgeführt werden, um die Haftung der lichtempfindlichen Schicht und ihre chemische Resistenz gegen Ätzlösungen und andere Substanzen zu erhöhen. Diese Behandlung erfolgt wie in GB-A 1,154,749 beschrieben. Die sich an die Entwicklung anschließende Wärmebehandlung ist beispielsweise eine Einbrennbehandlung des Schichtträgers und der darauf aufgebrachten Schicht bei Temperaturen unterhalb des Erweichungspunktes der Beschichtung. Für industrielle Anwendungen, insbesondere bei der Herstellung von Bauteilen für Mikroschaltungen auf Silizium-oder Siliziumdioxidträgern können die entwickelten Schichtträger mit einer gepufferten Flußsäurelösung geätzt werden. Die Bestandteile des erfindungsgemäßen Photoresists sind gegen derartige Ätzlösungen resistent und gewährleisten einen wirksamen Schutz der unbelichteten, mit dem Photoresist beschichteten Stellen des Schichtträgers.

Anhand der folgenden Beispiele werden die Vorteile, die das erfindungsgemäße lichtempfindliche Gemisch gegenüber homologen lichtempfindlichen Gemischen besitzt näher erläutert, ohne daß jedoch eine Einschränkung der Erfindung auf diese Beispiele stattfinden soll.

Beispiele 1a-1d

10,0 g 2,3,4-Trihydroxyphenylheptylketon und 32,2 g Naphthochinon-(1,2)-diazid-(2)-5-sulfonylchlorid werden in Dioxan zu einer 10%igen Lösung gelöst. Unter starkem Rühren werden langsam 100 ml einer 10 gewichtsprozentigen wäßrigen Natriumcarbonatlösung zugegeben. Die Lösung wird 2 Stunden bei Raumtemperatur gerührt und dann in 2,51 1n Salzsäure gegossen. Das ausgefallene Reaktionsprodukt wird abfiltriert, säurefrei gewaschen und an der Luft getrocknet. Die erhaltene Verbindung entspricht der allgemeinen Formel, wobei D Naphthochinon-(1,2)-diazid-(2)-5-sulfonyl ist. Das Beispiel wurde viermal wiederholt, um Wiederholbarkeit anzuzeigen unter der die erfindungsgemäßen Gemische erhalten werden.

Beispiel 2

Es wird verfahren wie in Beispiel 1, mit der Ausnahme, daß bei der Herstellung der Verbindung nach der allgemeinen Formel als Keton 2,3,4-Trihydroxyphenylmethylketon eingesetzt wird, wobei also die Heptyl-Gruppe von Beispiel 1 durch eine Methyl-Gruppe ersetzt wird und D Naphthochinon-(1,2)-diazid-(2)-5-sulfonyl ist.

Beispiel 3

Es wird verfahren wie in Beispiel 1, mit der Ausnahme, daß zur Herstellung der Verbindung nach der allgemeinen Formel als Reaktionsteilnehmer 2,3,4-Trihydroxyphenylpentylketon und Naphthochinon-(1,2)-diazid-(2)-5-sulfonylchlorid eingesetzt werden, wobei also die Heptyl-Gruppe durch eine Pentyl-Gruppe ersetzt wird und D Naphthochinon-(1,2)-diazid-(2)-5-sulfonyl ist.

Beispiel 4

Es wird verfahren wie in Beispiel 1, mit der Ausnahme, daß zur Herstellung der Verbindung nach der allgemeinen Formel als Reaktionsteilnehmer 2,3,4-Trihydroxyphenylnonylketon und Naphthochinon-(1,2)-diazid(2)-5-sulfonylchlorid eingesetzt werden, wobei die Heptyl-Gruppe durch eine Nonyl-Gruppe ersetzt wird und D Naphthochinon-(1,2)-diazid-(2)-5-sulfonyl ist.

Beispiel 5

Es wird verfahren wie in Beispiel 1, mit der Ausnahme, daß zur Herstellung der Verbindung nach der allgemeinen Formel als Reaktionsteilnehmer 2,3,4-Trihydroxyphenylundecylketon und Naphthochinon-(1,2)-diazid-(2)-5-sulfonylchlorid eingesetzt werden, wobei die Heptyl-Gruppe von Beispiel 1 durch eine Undecyl-Gruppe ersetzt wird und D Naphthochinon(1,2)-diazid-(2)-5-sulfonyl ist.

Beispiel 6

Es wird verfahren wie in Beispiel 1, mit der Ausnahme, daß als Reaktionsteilnehmer zur Herstellung der Verbindung nach der allgemeinen Formel 2,3,4-Trihydroxyphenylheptadecylketon und Naphthochinon-(1,2)-diazid-(2)-5-sulfonylchlorid eingesetzt werden, wobei die Heptyl-Gruppe von Beispiel 1 durch eine Heptadecyl-Gruppe ersetzt wird und D Naphthochinon-(1,2)-diazid-(2)-5-sulfonyl ist.

Beispiel 7

Es wird verfahren wie in Beispiel 1, mit der Ausnahme, daß zur Herstellung der Verbindung nach der allgemeinen Formel als Reaktionsteilnehmer 2,3,4-Trihydroxyphenylhexylketon und Naphthochinon-(1,2)-diazid-(2)-5-sulfonylchlorid eingesetzt werden, wobei die Heptyl-Gruppe von Beispiel 1 durch eine Hexyl-Gruppe ersetzt wird und D Naphthochinon-(1,2)-(2)-5-sulfonyl ist.

Beschichtungslösungen werden hergestellt, indem jeweils eines der wie vorstehend beschrieben hergestellten Naphthochinonderivate, von denen jedes eine andere Alkylketongruppe trägt, zusammen mit 26 g eines Kresol-Novolakharzes in 69 g Propylenglykolmethyletheracetat gelöst und das Produkt abfiltriert wird. Die in der Lösung verwendete Menge an Naphthochinonderivat wird jeweils so gewählt, daß das Absorptionsvermögen etwa 0,75 1/g cm beträgt. Die Lösung wird bei 5500 U/min auf einen Siliziumwafer aufgeschleudert und 30 Minuten lang bei 90 °C luftgetrocknet.

Die so erhaltenen Photoresists werden wie folgt bewertet: 10 Siliziumwafer, die jeweils mit einer ein Naphthochinonderivat nach einem der Beispiele 1-7 enthaltenden Beschichtungslösung beschichtet sind, werden mit einer Intensität zwischen 30 und 150 mJ/cm$^2$ (Belichtungsenergie) belichtet. In jedem Fall wird die Lichtdosis mit Hilfe eines Radiometers gemessen. Die Dicke ($T_0$) der auf die Wafer aufgetragenen Photoresistschicht wird jeweils mit Hilfe eines "Rudolf Film Thickness Monitor"-Gerätes bestimmt. Anschließend werden die Wafer nacheinander mit einer wäßrig-alkalischen Boratlösung (AZ 400 K) entwickelt. Die Entwicklerlösungen wurden so weit verdünnt, daß der Verlust an nicht belichteten Resistschichtteilen bei 5-15 nm/min liegt, so daß es möglich ist, eine möglichst hohe Lichtempfindlichkeit einzustellen und dennoch die Erosionsverluste auf ein vertretbares Maß zu beschränken. Der Ablösungsgrad der belichteten Schicht wird mit einem Laser-Interferometer überwacht. Aus den Linien des Laser-Interferometers wird bestimmt, wie dick die Photoresistschicht ist, die bei der jeweiligen Belichtungsdosis nach einer Entwicklungszeit (T) von einer Minute noch vorhanden ist. Die normierte Resistschichtdicke ($T/T_0$) wird gegen den Logarithmus der Belichtungsenergie aufgetragen, um eine Kontrastkurve gemäß der Beschreibung von G. C. Willson in "Introduction to Microlithography" (Einführung in den Mikroflachdruck), Kap. 3, S. 105, American Chemical Society, Washington, D.C., 1983, zu erhalten. Durch Extrapolation erhält man das Bild einer Geraden (Figur 1).

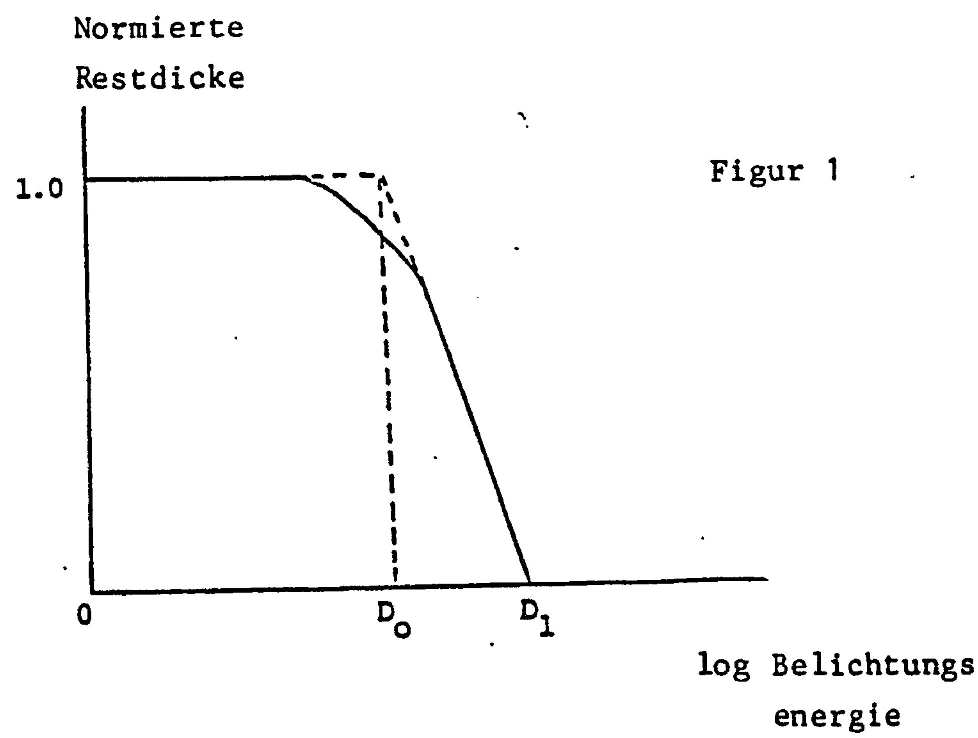


Figur 1

Die Neigung der Geraden gibt den Entwicklungskontrast des Photoresists an. Der Punkt ($D_1$), an dem die Gerade die Belichtungsachse schneidet, gibt die Lichtempfindlichkeit an, d. h., die Energie, die benötigt wird, um eine Photoresistschicht der Dicke $T_0$ in einer Minute zu entfernen, wobei der niedrigere Wert höhere Lichtempfindlichtkeit bedeutet.

Die 10 Photoresistgemische werden nach den vorstehend beschriebenen Verfahren bewertet. Die Naphthochinon-(1,2)-diazid-(2)-sulfonylgruppe ist in jedem Fall Naphthochinon-(1,2)-diazid-(2)-5-sulfonyl. Die Alkylketongruppe entspricht jeweils den Angaben von Tabelle 1. Für jede Verbindung wird nach der Auswertung eine Kontrastkurve aufgestellt. Die ermittelten Kontrast-und Lichtempfindlichkeitswerte und das jeweilige Verdünnungsverhältnis des Entwicklers sind ebenfalls in Tabelle 1 zusammengefaßt.

Tabelle 1

| Beispiel | Summenformel Alkylketon | Kontrast | Benötigte Belichtungs-energie mJ/cm$^2$ | Entwickler-konzentration |
|---|---|---|---|---|
| 1a | Heptyl | 1,95 | 94 | 1:3 |
| 1b | Heptyl | 1,72 | 110 | 1:3 |
| 1c | Heptyl | 1,80 | 94 | 1:3 |
| 1d | Heptyl | 1,83 | 100 | 1:3 |
| 2 | Methyl | 1,22 | 126 | 1:3,5 |
| 3 | Pentyl | 1,40 | 80 | 1:2,8 |
| 4 | Nonyl | 1,50 | 92 | 1:2,5 |
| 5 | Undecyl | 1,84 | 178 | 1:3 |
| 6 | Heptadecyl | 1,80 | 165 | 1:2,5 |
| 7 | Hexyl | 1,54 | 124 | 1:3 |

Aus Tabelle 1 geht eindeutig hervor, daß die erfindungsgemäßen Verbindungen der Beispiele 1a-1d, in denen das Alkylketon Heptylketon ist, Photoresists ergeben, die sich durch exzellenten Kontrast und hohe Lichtempfindlichkeit auszeichnen, im Gegensatz zu den Verbindungen nach den Beispielen 2-7, in denen das Alkylketon Methyl-, Pentyl-, Nonyl-, Undecyl-,Heptadecyl- oder Hexyl-Keton ist. Dies bedeutet, daß trotz einiger unbedeutender Schwankungen die Phenylheptylketonverbindung am besten geeignet ist, einen im wesentlichen recht hohen Bildkontrast zu bewahren, während gleichzeitig nur eine vergleichsweise geringe Belichtungsenergie erforderlich ist, um die belichteten Schichtbestandteile vollständig zu entfernen (d. h., hohe Lichtempfindlichkeit).

## Ansprüche

1. Lichtempfindliches Gemisch, das einen Naphthochinon-(1,2)-diazid-(2)-sulfonsäureester eines Pyrogallolalkylketons und ein wasserunlösliches, in wäßrig-alkalischen Lösungen lösliches oder mindestens quellbares harzartiges Bindemittel enthält, dadurch gekennzeichnet, daß es einen Naphthochinondiazidsulfonsäureester der allgemeinen Formel enthält

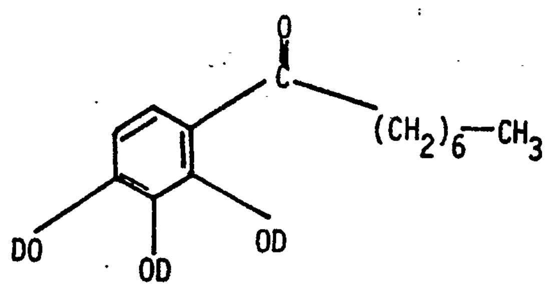

worin

D einen Naphthochinon-(1,2)-diazid-(2)-4-sulfonyl- oder einen Naphthochinon-(1,2)-diazid-(2)-5-sulfonyl-Rest bedeutet.

2. Gemisch nach Anspruch 1, dadurch gekennzeichnet, daß es als Bindemittel einen Phenolharz-Novolak enthält.

3. Gemisch nach Anspruch 1, dadurch gekennzeichnet, daß es als Bindemittel einen Kresolharz-Novolak enthält.

4. Gemisch nach Anspruch 1, dadurch gekennzeichnet, daß es als Bindemittel ein Polyvinylphenolharz enthält.

5. Gemisch nach den Ansprüchen 1 bis 4, dadurch gekennzeichnet, daß das Mischungsverhältnis zwischen Naphthochinondiazidsulfonsäureester und Bindemittel im Bereich von 1:1 bis etwa 1:10 liegt.

6. Lichtempfindliches, positiv arbeitendes Kopiermaterial, insbesondere zur Herstellung von Photoresists, aus einem Schichtträger und einer lichtempfindlichen Schicht, dadurch gekennzeichnet, daß die lichtempfindliche Schicht das Gemisch gemäß den Ansprüchen 1 bis 5 enthält.

7. Material nach Anspruch 6, dadurch gekennzeichnet, daß der Schichtträger aus einem Halbleitermaterial, aus Metall, aus Kunststoffolie, Holz, Papier, Keramik oder aus einem textilen Material besteht.

8. Material nach Anspruch 6 oder 7, dadurch gekennzeichnet, daß der Schichtträger ein Siliziumwafer ist.

9. Material nach Anspruch 6 oder 7, dadurch gekennzeichnet, daß der Schichtträger aus Aluminium besteht.

10. Material nach Anspruch 9, dadurch gekennzeichnet, daß der Schichtträger aus Aluminium besteht, dessen Oberfläche mechanisch oder elektrolytisch aufgerauht und anodisch oxidiert ist.

## Claims

1. Photosensitive mixture which contains a 1,2-naphthoquinone-2-diazide-sulphonate of a pyrogallol alkyl ketone and a water-insoluble resinous binder which is soluble or at least swellable in aqueous alkaline solutions, characterised in that it contains a naphthoquinone-diazide-sulphonate of the formula:

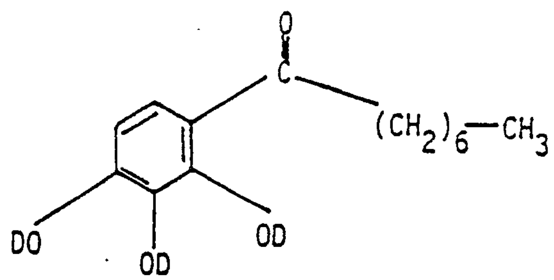

in which

D is a 1,2-naphthoquinone-2-diazide-4-sulphonyl or a 1,2-naphthoquinone-2-diazide-5-sulphonyl radical.

2. Mixture according to Claim 1, characterised in that it contains a phenolic resin novolak as binder.

3. Mixture according to Claim 1, characterised in that it contains a cresol resin novolak as binder.

4. Mixture according to Claim 1, characterised in that it contains a polyvinylphenol resin as binder.

5. Mixture according to Claims 1 to 4, characterised in that the mixing ratio between naphthoquinone-diazidesulphonate and binder is in the range from 1:1 to approximately 1:10.

6. Photosensitive positive-working copying material, in particular for producing photoresists, comprising a layer base and a photosensitive layer, characterised in that the photosensitive layer contains the mixture according to Claims 1 to 5.

7. Material according to Claim 6, characterised in that the layer base consists of semiconductor material, of metal, of plastic film, wood, paper, ceramics or of a textile material.

8. Material according to Claim 6 or 7, characterised in that the layer base is a silicon wafer.

9. Material according to Claim 6 or 7, characterised in that the layer base consists of aluminium.

10. Material according to Claim 9, characterised in that the layer base consists of aluminium whose surface has been mechanically or electrolytically roughened and anodically oxidised.

## Revendications

1. Composition photosensible qui contient un ester naphtoquinone-(1,2)-diazide-(2)-sulfonique d'une pyrogallolalkylcétone et un liant de type résine insoluble dans l'eau, soluble ou au moins susceptible de gonfler dans des solutions aqueuses-alcalines, caractérisée en ce qu'elle contient un ester naphtoquinonediazidesulfonique de formule générale

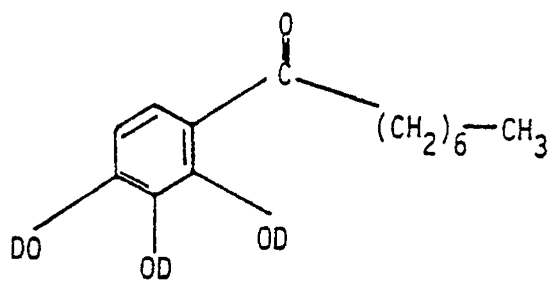

dans laquelle D représente un radical naphtoquinone-(1,2)-diazide-(2)-4-sulfonyle ou naphtoquinone-(1,2)-diazide-(2)-5-sulfonyle.

2. Composition selon la revendication 1, caractérisée en ce qu'elle contient en tant que liant une résine Novolaque phénolique.

3. Composition selon la revendication 1, caractérisée en ce qu'elle contient en tant que liant une résine Novolaque à base de crésol.

4. Composition selon la revendication 1, caractérisée en ce qu'elle contient en tant que liant une résine polyvinylphénolique.

5. Composition selon les revendications 1 à 4, caractérisée en ce que le rapport de mélange entre l'ester naphtoquinonediazidesulfonique et le liant se situe dans la plage de 1:1 à environ 1:10.

6. Matériau de reprographie photosensible travaillant en positif, en particulier pour la fabrication de photoresists, constitué d'un support de couche et d'une couche photosensible, caractérisé en ce que la couche photosensible contient la composition selon les revendications 1 à 5.

7. Matériau selon la revendication 6, caractérisé en ce que le support de couche est constitué d'un matériau semi-conducteur, de métal, d'une feuille de matière plastique, de bois, papier, céramique ou d'un matériau textile.

8. Matériau selon la revendication 6 ou 7, caractérisé en ce que le support de couche est une plaquette de silicium.

9. Matériau selon la revendication 6 ou 7, caractérisé en ce que le support de couche est constitué d'aluminium.

10. Matériau selon la revendication 9, caractérisé en ce que le support de couche est constitué d'aluminium dont la surface est grainée mécaniquement ou électrolytiquement et oxydée par anodisation.